**Europäisches Patentamt**

**European Patent Office**

**Office européen des brevets**

(19)

(11) Veröffentlichungsnummer: **0 132 552**

**A1**

(12) ## EUROPÄISCHE PATENTANMELDUNG

(21) Anmeldenummer: **84106383.7**

(22) Anmeldetag: **05.06.84**

(51) Int. Cl.⁴: **H 03 K 17/955**

(30) Priorität: **29.07.83 DE 3327329**

(43) Veröffentlichungstag der Anmeldung:
**13.02.85 Patentblatt 85/7**

(84) Benannte Vertragsstaaten:
**AT BE CH DE FR GB IT LI LU NL SE**

(71) Anmelder: **Buck, Robert**
**Vogelherdbogen 67**
**D-7992 Tettnang(DE)**

(71) Anmelder: **Marhofer, Gerd**
**Beckmannsbusch 67**
**D-4300 Essen-Bredeney(DE)**

(72) Erfinder: **Buck, Robert**
**Vogelherdbogen 67**
**D-7992 Tettnang(DE)**

(72) Erfinder: **Marhofer, Gerd**
**Beckmannsbusch 67**
**D-4300 Essen-Bredeney(DE)**

(74) Vertreter: **Gesthuysen, Hans Dieter, Dipl.-Ing. et al,**
**Patentanwälte Gesthuysen + von Rohr Huyssenallee 15**
**Postfach 10 13 33**
**D-4300 Essen 1(DE)**

(54) **Elektronisches, vorzugsweise berührungslos arbeitendes Schaltgerät.**

(57) Dargestellt und beschrieben ist ein elektronisches, berührungslos arbeitendes Schaltgerät, mit einem von außen kapazitiv beeinflußbaren Oszillator (10) und mit einem von dem Oszillator (10) über einen Schaltverstärker (11) steuerbaren elektronischen Schalter, wobei der Oszillator (10) ein Beeinflussungsnetzwerk (14) aufweist und im Beeinflussungsnetzwerk (14) eine Ansprechelektrode (15) vorgesehen ist und wobei der Oszillator (10) dann signifikant, d. h. den elektronischen Schalter steuernd beeinflußt wird, wen durch einen sich der Ansprechelektrode (15) nähernden Ansprechkörper die Impedanz zwischen der Ansprechelektrode (15) und einer auf Bezugspotential liegenden Gegenelektrode (16) einen Impedanzgrenzwert unterschritten hat.

Ein besonders gutes Funktionsverhalten des elektronischen Schaltgerätes ist dadurch erreicht, daß der Oszillator (10) so ausgeführt ist, daß er ohne eine Beeinflussung durch das Beeinflussungsnetzwerk (14) mit einer oberhalb eines Amplitudengrenzwertes liegenden Schwingungsamplitude schwingt und nur noch mit einer unterhalb des Amplitudengrenzwertes liegenden Schwingungsamplitude schwingt, wenn er durch das Beeinflussungsnetzwerk (14) wie bei einer Gegenkopplung signifikant beeinflußt worden ist.

Die Erfindung betrifft ein elektronisches, vorzugsweise berührungslos arbeitendes Schaltgerät, mit einem von außen vorzugsweise kapazitiv beeinflußbaren
Oszillator und mit einem von dem Oszillator - ggf. über einen Schaltverstärker -
steuerbaren elektronischen Schalter, z. B. einem Transistor, einem Thyristor
oder einem Triac, wobei der Oszillator ein Beeinflussungsnetzwerk aufweist
und im Beeinflussungsnetzwerk eine Ansprechelektrode vorgesehen ist und wobei
der Oszillator dann signifikant, d. h. den elektronischen Schalter steuernd
beeinflußt wird, wenn durch einen sich der Ansprechelektrode nähernden Ansprechkörper die Impedanz zwischen der Ansprechelektrode und einer auf Bezugspotential liegenden Gegenelektrode einen Impedanzgrenzwert unterschritten
hat.

Elektronische Schaltgeräte der hier grundsätzlich in Rede stehenden Art sind
kontaktlos ausgeführt und werden in zunehmendem Maße anstelle von elektrischen,
mechanisch betätigten Schaltgeräten, die kontaktbehaftet ausgeführt sind, in
elektrischen Meß-, Steuer- und Regelkreisen verwendet. Das gilt insbesondere
für sogenannte Annäherungsschalter, d. h. für elektronische Schaltgeräte, die
berührungslos arbeiten. Mit solchen Annäherungsschaltern wird indiziert, ob
sich ein Beeinflussungselement, für das der entsprechende Annäherungsschalter
sensitiv ist, dem Annäherungsschalter hinreichend weit genähert hat. Hat sich
nämlich ein Beeinflussungselement, für das der entsprechende Annäherungsschalter sensitiv ist, dem Annäherungsschalter hinreichend weit genähert, so wird
der elektronische Schalter umgesteuert, d. h. bei einem als Schließer ausgeführten Schaltgerät wird der bisher nichtleitende elektronische Schalter nunmehr leitend, während bei einem als Öffner ausgeführten Schaltgerät der bisher leitende elektronische Schalter nunmehr sperrt. (Mit Schaltgeräten der in
Rede stehenden Art kann auch indiziert werden, ob eine physikalische Größe
eines Beeinflussungsmediums, für die das Schaltgerät sensitiv ist, einen entsprechenden Wert erreicht hat.)

- 1 -

Wesentlicher Bestandteil von elektronischen Schaltgeräten der zuvor grundsätzlich beschriebenen Art ist also u. a. ein von außen beeinflußbarer Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 55 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 733, 26 28 427, 27 11 877 und 27 44 785). Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit den Problemen "Erzeugung einer Speisespannung für den Oszillator", "Ausbildung des Oszillators", "Einschaltimpulsverhinderung", "Kurzschlußfestigkeit". Mit diesen Problemen und deren Lösungen (und mit anderen, bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 16 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692.

Elektronische Schaltgeräte mit einem von außen induktiv beeinflußbaren Oszillator, also induktive Annäherungsschalter, sind weniger problematisch als solche mit einem von außen kapazitiv beeinflußbaren Oszillator, also als kapazitive Annäherungsschalter. Einerseits unterscheiden sich induktive Annäherungsschalter von kapazitiven Annäherungsschalter insoweit, als bei induktiven Annäherungs-

- 2 -

schaltern der Oszillator komplett im Schaltgerät vorhanden ist, ständig schwingt und bei einer äußeren Beeinflussung eine quantitative Änderung der Schwingungsamplitude ausgewertet wird, während bei kapazitiven Annäherungsschaltern der Oszillator erst dann komplett ist, wenn durch die äußere Beeinflussung eine hinreichend große Beeinflussungskapazität zwischen der Ansprechelektrode und der Gegenelektrode entstanden ist, der Oszillator also nur dann schwingt, wenn durch die äußere Beeinflussung eine hinreichend große Beeinflussungskapazität entstanden ist, bei einer äußeren Beeinflussung also eine qualitative Änderung der Schwingungsamplitude ausgewertet wird, - Oszillator schwingt nicht oder Oszillator schwingt (mit einer Schwingungsamplitude oberhalb eines Amplitudengrenzwertes). Andererseits ist bei induktiven Annäherungsschaltern das Verhältnis von Eigenbedämpfung des Oszillators zu Beeinflussungsbedämpfung günstiger als bei kapazitiven Annäherungsschaltern das Verhältnis von Eigenkapazität der Ansprechelektrode zu Beeinflussungskapazität.

Der Erfindung liegt nun die Aufgabe zugrunde, das eingangs beschriebene elektronische, vorzugsweise berührungslos arbeitende Schaltgerät hinsichtlich seines Funktionsverhaltens zu verbessern.

Das erfindungsgemäße elektronische, vorzugsweise berührungslos arbeitende Schaltgerät, bei dem die zuvor aufgezeigte Aufgabe gelöst ist, ist zunächst und im wesentlichen dadurch gekennzeichnet, daß der Oszillator so ausgeführt ist, daß er ohne eine Beeinflussung durch das Beeinflussungsnetzwerk mit einer oberhalb eines Amplitudengrenzwertes liegenden Schwingungsamplitude schwingt und nur noch mit einer unterhalb des Amplitudengrenzwertes liegenden Schwingungsamplitude schwingt, wenn er durch das Beeinflussungsnetzwerk wie bei einer Gegenkopplung signifikant beeinflußt worden ist.

Der allgemeine Erfindungsgedanke ist also der, einen kapazitiven Annäherungsschalter so auszuführen, daß der Oszillator komplett im Schaltgerät vorhanden ist, ständig schwingt und bei einer äußeren Beeinflussung eine quantitative Änderung der Schwingungsamplitude ausgewertet wird.

- 3 -

Im einzelnen gibt es verschiedene Möglichkeiten, das erfindungsgemäße elektronische Schaltgerät auszugestalten und weiterzubilden, was im folgenden nur beispielhaft erläutert werden soll.

Grundsätzlich gibt es eine Vielzahl von für das erfindungsgemäße elektronische Schaltgerät brauchbaren Ausführungsformen von Oszillatoren. Gleichwohl kann es sich empfehlen, den Oszillator als LC-Oszillator auszuführen, insbesondere dergestalt, daß der Oszillator einen in Emitterschaltung betriebenen Oszillatortransistor und einen Emitterwiderstand aufweist. Hierbei empfiehlt es sich dann, den Emitterwiderstand einstellbar auszuführen, so daß mit Hilfe des einstellbaren Emitterwiderstandes der Schaltabstand des erfindungsgemäßen elektronischen Schaltgerätes eingestellt werden kann.

Zu jedem - selbsterregten - Oszillator gehört bekanntlich ein Rückkopplungsnetzwerk, - weil nur dann die Barkhausen-Bedingung erfüllt sein kann. Grundsätzlich lassen sich deshalb Oszillatoren über das Rückkopplungsnetzwerk beeinflussen - was bei den elektronischen Schaltgeräten, von denen die Erfindung ausgeht, auch geschieht. Bei dem erfindungsgemäßen elektronischen Schaltgerät ist jedoch einerseits ein Rückkopplungsnetzwerk, welcher Art auch immer, vorhanden, andererseits das Beeinflussungsnetzwerk vorgesehen. Hier ist also das Beeinflussungsnetzwerk kein eigentliches Rückkopplungsnetzwerk, - weshalb es zuvor geheißen hat, daß der Oszillator dann nur noch mit einer unterhalb des Amplitudengrenzwertes liegenden Schwingungsamplitude schwingt, wenn er durch das Beeinflussungsnetzwerk "wie bei einer Gegenkopplung" signifikant beeinflußt worden ist. Weil nun bei dem erfindungsgemäßen elektronischen Schaltgerät das Beeinflussungsnetzwerk kein eigentliches Rückkopplungsnetzwerk ist, gibt es eine Vielzahl von Möglichkeiten, das Beeinflussungsnetzwerk anzuschließen.

Bei einer Ausführungsform des erfindungsgemäßen elektronischen Schaltgerätes, bei der der Oszillator einen in Emitterschaltung betriebenen Oszillatortran-

- 4 -

sistor und einen Emitterwiderstand aufweist, kann das Beeinflussunqsnetzwerk einerseits an die Verbindunq von Emitter des Oszillatortransistors und Emitterwiderstand und andererseits an die Ansprechelektrode anqeschlossen sein.

Möqlich sind auch Ausführunqsformen von erfindungsgemäßen elektronischen Schaltqeräten, bei denen das Beeinflussungsnetzwerk an den Einqanq des Oszillators angeschlossen ist. Handelt es sich um eine Ausführunqsform des erfindungsgemäßen elektronischen Schaltgerätes, bei der der Oszillator als LC-Oszillator ausqeführt ist, also einen LC-Schwingkreis aufweist, so kann das Beeinflussunqsnetzwerk einerseits an das dem Bezuqspotential ferne, also das "heiße" Ende des LC-Schwinqkreises und andererseits an die Ansprechelektrode angeschlossen sein.

Das bei dem erfindunqsqemäßen elektronischen Schaltgerät vorgesehene Bee- influssunqsnetzwerk kann qrundsätzlich beliebiq ausqeführt sein, - wenn nur sicherqestellt ist, daß dann, wenn durch einen sich der Ansprechelektrode nähernden Ansprechkörper die Impedanz zwischen der Ansprechelektrode und der auf Bezuqspotential liegenden Geqenelektrode einen Impedanzqrenzwert unterschritten hat, der Oszillator nur noch mit einer unterhalb des Amoli- tudengrenzwertes liegenden Schwingunqsamplitude schwinqt. Gleichwohl gibt es Ausführunqsformen von Beeinflussungsnetzwerken, die für das erfindungsgemäße elektronische Schaltgerät besonders geeignet sind. Eine solche bevorzugte Ausführungsform ist nun dadurch gekennzeichnet, daß das Beeinflussungsnetzwerk einen FET-n-Kanal-Verarmungstyp-Transistor aufweist, die Drain- Elektrode des FET-n-Kanal-Verarmungstyp-Transistors an ein Pluspotential angeschlossen ist, an die Source-Elektrode des FET-n-Kanal-Verarmungstyp- Transistors ein Source-Widerstand und an die Gate-Elektrode des FET-n-Kanal- Verarmungstyp-Transistors ein Gate-Widerstand angeschlossen sind sowie die nicht an den FET-n-Kanal-Verarmungstyp-Transistor angeschlossenen Enden des Source-Widerstandes und des Gate-Widerstandes miteinander verbunden sind.

Dabei kann dann die Verbindung von Source-Widerstand und Gate-Widerstand entweder an die Verbindung von Emitter des Oszillatortransistors und Emitterwiderstand oder an das dem Bezugspotential ferne, also das "heiße" Ende des LC-Schwingkreises angeschlossen sein.

Schließlich geht eine weitere Lehre der Erifndung dahin, bei den zuletzt beschriebenen Ausführungsformen des erfindungsgemäßen elektronischen Schaltgerätes dem Gate-Widerstand einen Spannungsteilerkondensator parallel zu schalten.

Im folgenden wird die Erfindung anhand einer lediglich Ausführungsbeispiele darstellenden Zeichnung nochmals erläutert; es zeigt

Fig. 1    das Blockschaltbild eines erfindungsgemäßen elektronischen, berührungslos arbeitenden Schaltgerätes,

Fig. 2    einen Ausschnitt aus der Schaltung eines ersten Ausführungsbeispiels eines erfindungsgemäßen elektronischen Schaltgerätes und

Fig. 3    einen Ausschnitt aus der Schaltung einer zweiten Ausführungsform eines erfindungsgemäßen elektronischen Schaltgerätes.

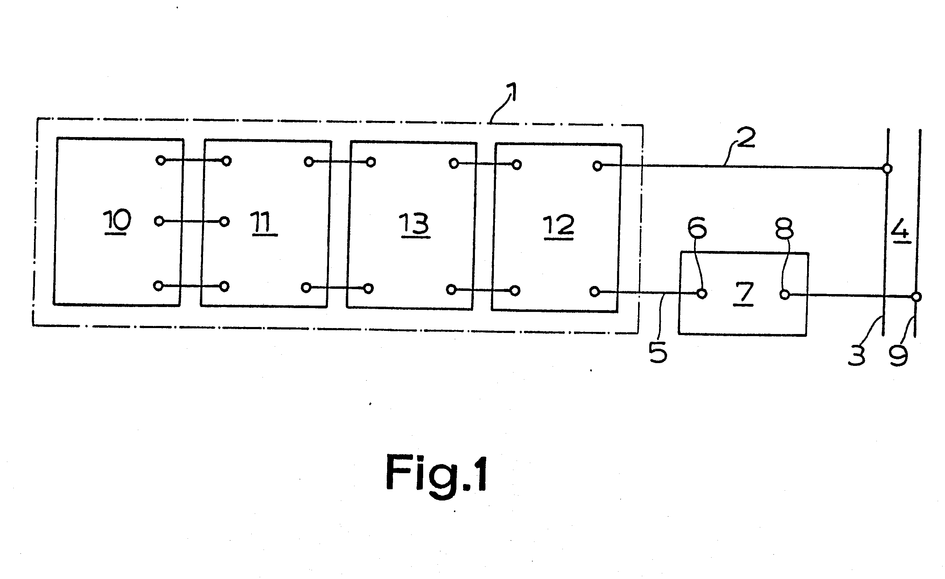

Das in Fig. 1 in Form eines Blockschaltbildes dargestellte elektronische Schaltgerät 1 arbeitet berührungslos, d. h. es spricht auf einen sich annähernden, in den Figuren nicht dargestellten Ansprechkörper an und ist über einen Außenleiter 2 mit einem Pol 3 einer Spannungsquelle 4 und nur über einen weiteren Außenleiter 5 mit einem Anschluß 6 eines Verbrauchers 7 verbindbar, wobei der andere Anschluß 8 des Verbrauchers 7 an den anderen Pol 9 der Spannungsquelle 4 angeschlossen ist. Mit anderen Worten ist das dargestellte elektronische Schaltgerät 1 über insgesamt nur zwei Außenleiter 2, 5 einerseits an die Spannungsquelle 4 und andererseits an den Verbraucher 7 anschließbar.

- 6 -

(Die Lehre der Erfindung ist unabhängig davon, ob das Schaltgerät 1 zwei
Außenleiter 2, 5 hat, wie im Ausführungsbeispiel nach Fig. 1, oder ob drei
oder gar mehr als drei Außenleiter vorgesehen sind.)

In seinem grundsätzlichen Aufbau besteht das in Fig. 1 dargestellte elektronische, d. h. kontaktlose Schaltgerät 1 aus einem von außen kapazitiv beeinflußbaren Oszillator 10, aus einem dem Oszillator 10 nachgeschalteten Schaltverstärker 11, aus einem von dem Oszillator 10 über den Schaltverstärker 11
steuerbaren elektronischen Schalter 12, z. B. einem Thyristor, und aus einer
Speiseschaltung 13 zur Erzeugung der Speisespannung für den Oszillator 10
und den Schaltverstärker 11.

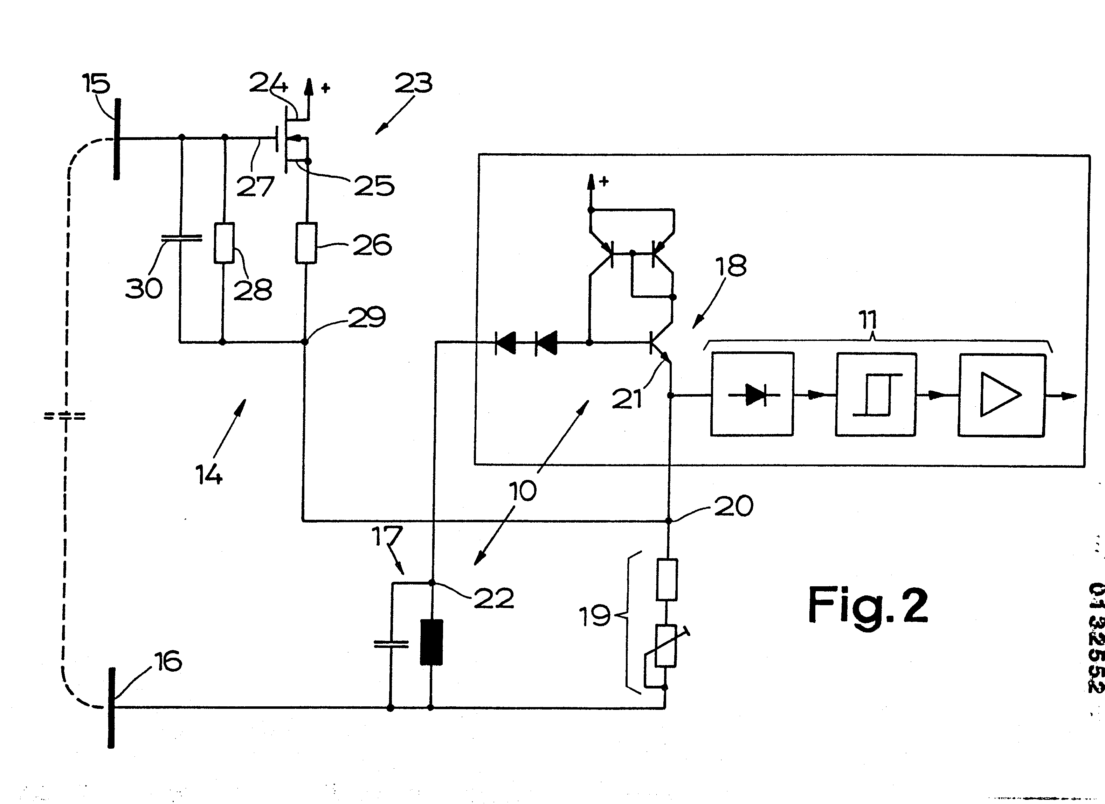

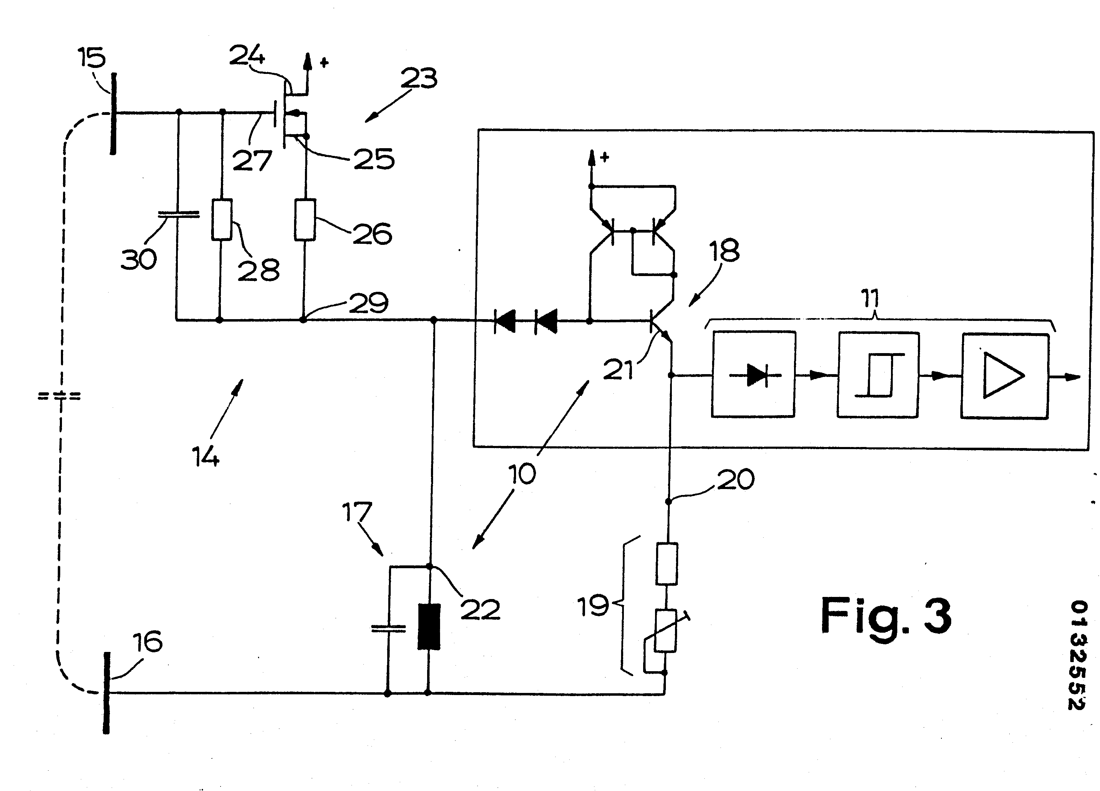

Wie die Fig. 2 und 3 zeigen, weist der Oszillator 10 ein Beeinflussungsnetzwerk 14 auf und ist im Beeinflussungsnetzwerk 14 eine Ansprechelektrode 15
vorgesehen. Dabei wird der Oszillator 10 dann signifikant, d. h. den elektronischen Schalter 12 steuernd beeinflußt, wenn durch den sich der Ansprechelektrode 15 nähernden, in den Fig. nicht dargestellten Ansprechkörper die Impedanz zwischen der Ansprechelektrode 15 und einer auf Bezugspotential liegenden Gegenelektrode 16 einen Impedanzgrenzwert unterschritten hat.

Erfindungsgemäß ist der Oszillator 10 so ausgeführt, daß er ohne eine Beeinflussung durch das Beeinflussungsnetzwerk 14 mit einer oberhalb eines Amplitudengrenzwertes liegenden Schwingungsamplitude schwingt und nur noch mit
einer unterhalb des Amplitudengrenzwertes liegenden Schwingungsamplitude
schwingt, wenn er durch das Beeinflussungsnetzwerk 14 wie bei einer Gegenkopplung signifikant beeinflußt worden ist.

In den in den Fig. 2 und 3 dargestellten Ausführungsbeispielen ist der Oszillator 10 als LC-Oszillator ausgeführt; der Oszillator 10 weist also einen
LC-Schwingkreis 17 auf. Im übrigen weist der Oszillator 10 einen in Emitterschaltung betriebenen Oszillatortransistor 18 und einen Emitterwiderstand 19
auf, wobei der Emitterwiderstand 19 einstellbar ist.

- 7 -

In dem in Fig. 2 dargestellten Ausführungsbeispiel ist das Beeinflussungsnetzwerk 14 einerseits an die Verbindung 20 von Emitter 21 des Oszillatortransistors 18 und Emitterwiderstand 19 und andererseits an die Ansprechelektrode 15 angeschlossen. Demgegenüber zeigt die Fig. 3 eine Ausführungsform, bei der das Beeinflussungsnetzwerk 14 einerseits an das dem Bezugspotential ferne, also das "heiße" Ende 22 des LC-Schwinkreises 17 und andererseits an die Ansprechelektrode 15 angeschlossen ist.

Den beiden in den Fig. 2 und 3 dargestellten Ausführungsbeispielen ist gemeinsam, daß das Beeinflussungsnetzwerk 14 einen FET-n-Kanal-Verarmungstyp-Transistor 23 aufweist, die Drain-Elektrode 24 des FET-n-Kanal-Verarmungstyp-
Transistors 23 an ein Pluspotential angeschlossen ist, an die Source-Elektrode 25 des FET-n-Kanal-Verarmungstyp-Transistors 23 ein Source-Widerstand 26
und an die Gate-Elektrode 27 des FET-n-Kanal-Verarmungstyp-Transistors 23 ein
Gate-Widerstand angeschlossen sind sowie die nicht an die FET-n-Kanal-Verarmungstyp-Transistor 23 angeschlossenen Enden des Source-Widerstandes 26 und
des Gate-Widerstandes 28 miteinander verbunden sind. Während nun im Ausführungsbeispiel nach Fig. 2 die Verbindung 29 von Source-Widerstand 26 und
Gate-Widerstand 28 an die Verbindung 20 von Emitter 21 des Oszillatortransistors 18 und Emitterwiderstand 19 angeschlossen ist, ist im Ausführungsbeispiel nach Fig. 3 die Verbindung 29 von Source-Widerstand 26 und Gate-
Widerstand 28 an das dem Bezugspotential ferne, also das "heiße" Ende 22
des LC-Schwingkreises 19 angeschlossen.

Schließlich zeigen die Fig. 2 und 3 insoweit eine bevorzugte Ausführungsform
des erfindungsgemäßen Schaltgerätes 1, als dem Gate-Widerstand 28 ein Spannungsteilerkondensator 30 parallelgeschaltet ist. Bei dieser Ausführungsform
wird also mit Hilfe des Gate-Widerstandes 28 nur der Gleichspannungs-Arbeitspunkt des FET-n-Kanal-Verarmungstyp-Transistors 23 vorgegeben, während der
Spannungsteilerkondensator 30 und die Beeinflussungskapazität zwischen der
Ansprechelektrode 15 und der Gegenelektrode 16 einen kapazitiven Spannungsteiler bilden.

- 8 -

**0132552**

(Während es einleitend heißt, daß die Erfindung ein elektronisches, "vorzugsweise berührungslos" arbeitendes Schaltgerät mit einem von außen "vorzugsweise kapazitiv" beeinflußbaren Oszillator betrifft, ist dann immer nur ein berührungslos arbeitendes Schaltgerät mit einem kapazitiv beeinflußbaren Oszillator behandelt worden. Grundsätzlich läßt sich die Lehre der Erfindung aber auch auf elektronische, durch Berührung arbeitende Schaltgeräte anwenden, die einen von außen ohmisch-kapazitiv oder ohmisch beeinflußbaren Oszillator aufweisen.)

Patentansprüche:

1. Elektronisches, vorzugsweise berührungslos arbeitendes Schaltgerät, mit einem von außen vorzugsweise kapazitiv beeinflußbaren Oszillator und mit einem von dem Oszillator - ggf. über einen Schaltverstärker - steuerbaren elektronischen Schalter, z. B. einem Transistor, einem Thyristor oder einem Triac, wobei der Oszillator ein Beeinflussungsnetzwerk aufweist und im Beeinflussungsnetzwerk eine Ansprechelektrode vorgesehen ist und wobei der Oszillator dann signifikant, d. h. den elektronischen Schalter steuernd beeinflußt wird, wenn durch einen sich der Ansprechelektrode nähernden Ansprechkörper die Impedanz zwischen der Ansprechelektrode und einer auf Bezugspotential liegenden Gegenelektrode einen Impedanzgrenzwert unterschritten hat, d a d u r c h   g e k e n n z e i c h n e t, daß der Oszillator (10) so ausgeführt ist, daß er ohne eine Beeinflussung durch das Beeinflussungsnetzwerk (14) mit einer oberhalb eines Amplitudengrenzwertes liegenden Schwingungsamplitude schwingt und nur noch mit einer unterhalb des Amplitudengrenzwertes liegenden Schwingungsamplitude schwingt, wenn er durch das Beeinflussungsnetzwerk (14) wie bei einer Gegenkopplung signifikant beeinflußt worden ist.

2. Elektronisches Schaltgerät nach Anspruch 1, dadurch gekennzeichnet, daß der Oszillator (10) als LC-Oszillator ausgeführt ist, also einen LC-Schwingkreis (17) aufweist.

3. Elektronisches Schaltgerät nach Anspruch 1 oder 2, dadurch gekennzeichnet, daß der Oszillator (10) einen in Emitterschaltung betriebenen Oszillatortransistor (18) und einen Emitterwiderstand (19) aufweist.

4. Elektronisches Schaltgerät nach Anspruch 3, dadurch gekennzeichnet, daß der Emitterwiderstand (19) einstellbar ist.

- 1 -

5. Elektronisches Schaltgerät nach Anspruch 3 oder 4, dadurch gekennzeichnet, daß das Beeinflussungsnetzwerk (14) einerseits an die Verbindung (20) von Emitter (21) des Oszillatortransistors (18) und Emitterwiderstand (19) und andererseits an die Ansprechelektrode (15) angeschlossen ist.

6. Elektronisches Schaltgerät nach einem der Ansprüche 2 bis 4, dadurch gekennzeichnet, daß das Beeinflussungsnetzwerk (14) einerseits an das dem Bezugspotential ferne, also an das "heiße" Ende (22) des LC-Schwingkreises (17) und andererseits an die Ansprechelektrode (15) angeschlossen ist.

7. Elektronisches Schaltgerät nach einem der Ansprüche 1 bis 6, dadurch gekennzeichnet, daß das Beeinflussungsnetzwerk (14) einen FET-n-Kanal-Verarmungstyp-Transistor (23) oder einen FET-p-Kanal-Anreicherungstyp-Transistor aufweist.

8. Elektronisches Schaltgerät nach Anspruch 7, wobei das Beeinflussungsnetzwerk einen FET-n-Kanal-Verarmungstyp-Transistor aufweist, dadurch gekennzeichnet, daß die Drain-Elektrode (24) des FET-n-Kanal-Verarmungstyp-Transistors (23) an ein Pluspotential angeschlossen ist, an die Source-Elektrode (25) des FET-n-Kanal-Verarmungstyp-Transistors (23) ein Source-Widerstand (26) und an die Gate-Elektrode (27) des FET-n-Kanal-Verarmungstyp-Transistors (23) ein Gate-Widerstand (28) angeschlossen sind sowie die nicht an den FET-n-Kanal-Verarmungstyp-Transistor (23) angeschlossenen Enden des Source-Widerstandes (26) und des Gate-Widerstandes (28) miteinander verbunden sind.

9. Elektronisches Schaltgerät nach den Ansprüchen 5 und 8, dadurch gekennzeichnet, daß die Verbindung (29) von Source-Widerstand (26) und Gate-Widerstand (28) an die Verbindung (20) von Emitter (21) des Oszillatortransistors (18) und Emitterwiderstand (19) angeschlossen ist.

- 2 -

10. Elektronisches Schaltgerät nach den Ansprüchen 6 und 8, dadurch gekennzeichnet, daß die Verbindung (29) von Source-Widerstand (26) und Gate-Widerstand (28) an das dem Bezugspotential ferne, also das "heiße" Ende (22) des LC-Schwingkreises (17) angeschlossen ist.

11. Elektronisches Schaltgerät nach einem der Ansprüche 8 bis 10, dadurch gekennzeichnet, daß dem Gate-Widerstand (28) ein Spannungsteilerkondensator (30) parallelgeschaltet ist.

0132552

Fig.1

Fig.2

0132552

3/3

0132552

Fig. 3

### Europäisches Patentamt

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| D,A | DE-B-2 203 039  (R. BUCK)<br>* Figur 2; Patentanspruch 1 * | 1 | H 03 K  17/955 |
| A | DE-A-2 739 786  (W. TURCK GMBH & CO. KG)<br>* Figur 1 * | 1 | |
| A | US-A-3 333 160  (A. GORSKI)<br>* Figur 2; Spalte 2, Zeile 56 - Spalte 3, Zeile 52 * | 1,2 | |
| A | EP-A-0 078 676  (FUJITSU LTD.)<br>* Figur 2 * | | |
| A | US-A-3 483 437  (J.J. COYNE)<br>* Figur 4; Spalte 6, Zeilen 10-57 * | 1,2 | |

-----

| RECHERCHIERTE SACHGEBIETE (Int. Cl. ³) |
|---|
| G 08 B  13/26<br>H 03 K  17/955<br>H 03 K  17/96 |

Der vorliegende Recherchenbericht wurde für alle Patentansprüche erstellt.

| Recherchenort | Abschlußdatum der Recherche | Prüfer |
|---|---|---|
| BERLIN | 07-09-1984 | ARENDT M |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82